# EUROPEAN PATENT APPLICATION

(11) **EP 1 471 580 A2**
(43) Date of publication of application: **27.10.2004**
(21) Application number: 04291043.0
(22) Date of filing: 22.04.2004
(51) Int. Cl.: H01L 29/73, H01L 29/423

(54) **Bipolar transistor and method of producing same**

(30) Priority: 24.04.2003 JP 2003120393
(71) Applicant: SONY CORPORATION, Tokyo (JP)
(72) Inventor: Kobayashi, Junichiro, Shinagawa-ku, Tokyo (JP)
(74) Representative: Thévenet, Jean-Bruno

(57) **Abstract**

A semiconductor device, able to be produced while suppressing the occurrence of mesa shaped abnormalities without restriction as to the pattern layout, the type of etchant used, etc., provided with a semiconductor mesa portion including a stack of a collector layer (12), a base layer (13), and an emitter layer (14) on a substrate (10) and functioning as an active region of a bipolar transistor, a base contact pad mesa portion (PBM) separated from this by a predetermined distance and having a height the same as the top surface of the base layer (13), and a conductor layer integrally formed with a base electrode (17a) connected to the base layer (13), a base contact pad electrode (17b) formed on the base contact pad mesa portion (PBM) in a region other than near the edges of the top surface of the base contact pad mesa portion (PBM), and an interconnect (17c) connecting these, and a method of producing the same.

## Description

### BACKGROUND OF THE INVENTION

### 1. Field of the Invention

The present invention relates to a semiconductor device having bipolar transistors and a method of producing the same, more particularly relates to a semiconductor device having heterojunction bipolar transistors and a method of producing the same.

### 2. Description of the Related Art

The transistors used for semiconductor devices may be roughly divided into bipolar transistors and metal oxide semiconductor (MOS) field effect transistors and other field effect transistors.

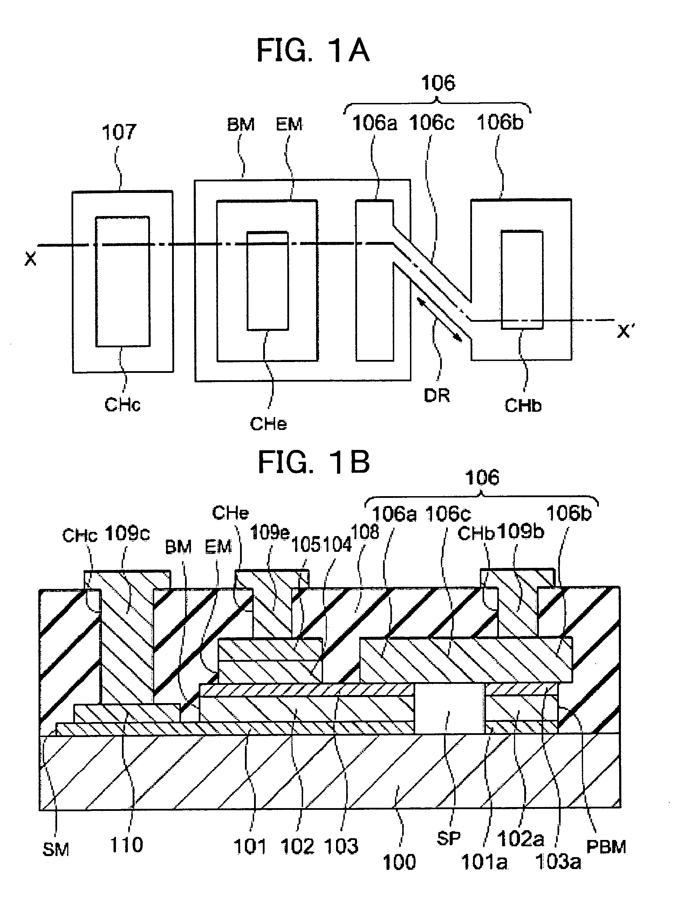

One type of bipolar transistor is a heterojunction bipolar transistor (HBT). *IEICE Technical Reports,* ED99-262 (Institute of Electronics, Information and Communication Engineers) discloses a base electrode takeout portion able to lower the capacity between a base and a collector of an InP/InGaAs-based HBT. FIG. 1A is a plane view showing such an HBT, and FIG. 1B is a cross-sectional view along the line X-X' of FIG. 1A. A substrate 100 of InP has a sub-collector layer 101 of an n⁺-type InGaAs and forming a collector takeout layer, a collector layer 102 of an n⁻-type InGaAs, a base layer 103 of a p⁺-type InGaAs, an emitter layer 104 of an n-type InP, an emitter cap layer (not shown) of an n⁺-type InP and InGaAs, etc. successively stacked on each other.

An emitter electrode 105 is formed connected to the emitter cap layer. For forming a base contact, the emitter cap layer and the emitter layer 104 are removed in part to form an emitter mesa portion EM. A base electrode 106a is formed connected to the base layer 103. The base layer 103 and the collector layer 102 are formed with a base mesa portion BM. The sub-collector layer 101 is formed with a sub-collector mesa portion SM, while a collector electrode 110 is formed connected to the sub-collector layer 101.

At a position a predetermined distance from an edge of the base mesa portion BM, a base contact pad base mesa portion PBM comprised of a layer 101a of the same layer as the sub-collector layer 101, a layer 102a of the same layer as the collector layer 102, and a layer 103a of the same layer as the base layer 103 is formed. The base contact pad base mesa portion PBM is formed with a base contact pad electrode 106b. Here, the base layer 103 formed under the base electrode 106a and the layer 103a formed under the base contact pad electrode 106b were originally the same layer, the heights of the surfaces of the two layers are the same, and the base electrode 106a and the base contact pad electrode 106b are connected by an interconnect 106c. The area below the conductive layer 106 between the base mesa portion BM and the base contact pad base mesa portion PBM forms a space SP. The interconnect 106c is formed floating above this.

A heterojunction bipolar transistor HBT is formed as described above. An insulating film 108 is formed covering the entire HBT. The insulating film 108 is formed with an emitter contact hole CHe reaching the emitter electrode 105, a base contact hole CHb reaching the base contact pad electrode 106b, and a collector contact hole CHc reaching the collector electrode 110. The emitter contact hole CHe is formed with an emitter contact plug interconnect 109e connected with the emitter electrode 105. The base contact hole CHb is formed with a base contact plug interconnect 109b connected with the base contact pad electrode 106b. The collector contact hole CHc is formed with a collector contact plug interconnect 109c connected with the collector electrode 110.

Here, the drawn direction DR of the interconnect 106c is for example made the [001] direction or the [010] direction of an InP crystalline orientation of the substrate due to the following production reasons.

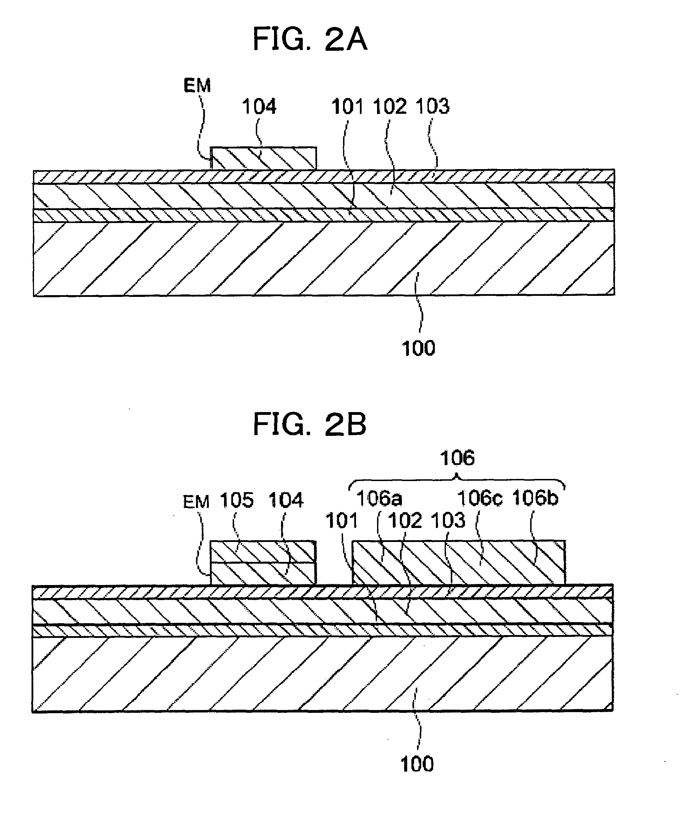

A method of producing the HBT will be described next referring to the drawings. As shown in FIG. 2A, a substrate 100 of InP is successively formed with, by a molecular beam epitaxy (MBE) or a metal organic chemical vapor deposition (MOCVD), the n⁺-type InGaAs as the sub-collector layer 101, the n⁻-type InGaAs as the collector layer 102, the p⁺-type InGaAs as the base layer 103, an n-type InP as the emitter layer 104, and an n⁺-type InP and InGaAs as the emitter cap layer (not shown). Next, a resist film (not shown) is formed in the pattern of the emitter mesa portion EM. This is used as a mask for etching to process the emitter cap layer (not shown) and the emitter layer 105 to the emitter mesa portion EM and to expose the surface of the base layer 103.

As shown in FIG. 2B, an emitter electrode 105 is formed by vapor deposition of a conductive layer for example by using the lift-off method and to form a conductive layer 106 comprised of a base electrode 106a, a base contact pad electrode 106b, and an interconnect 106c. Here, the conductive layer 106 is arranged so that the interconnect 106c extends in the [001] direction or the [010] direction of the InP crystalline orientation of the substrate 100 as shown in FIG. 1A.

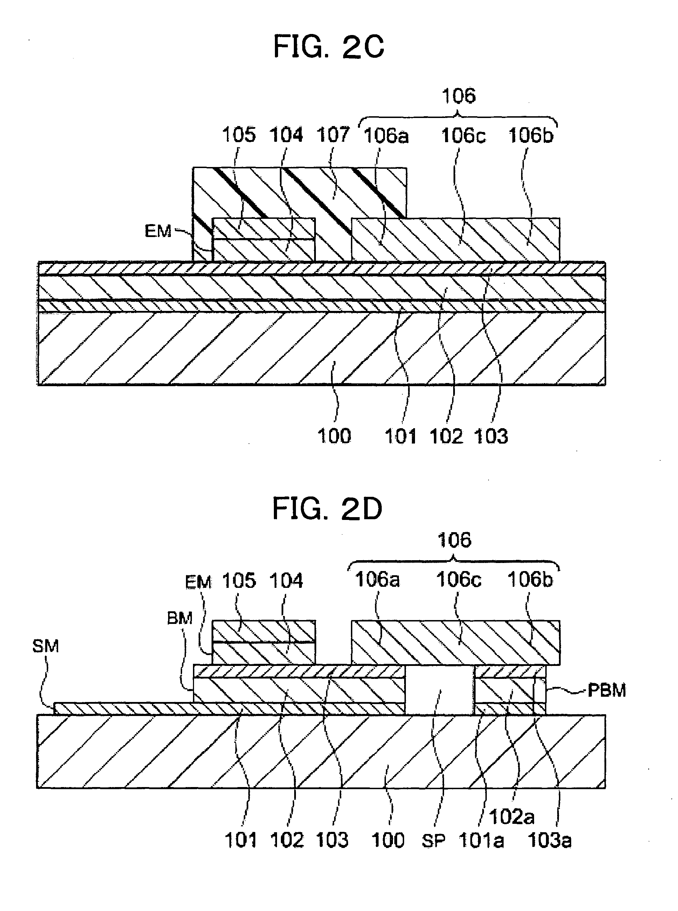

Next, as shown in FIG. 2C, a resist film 107 is formed in the pattern of the base mesa portion BM.

As shown in FIG. 2D, the base layer 103 and the collector layer 102 are etched using the resist film 107 as a mask to form the base mesa portion BM. Another resist film (not shown) is formed in the pattern of the sub-collector mesa portion SM. This is used as a mask for etching to process the sub-collector layer 101 to the sub-collector mesa portion SM to isolate the element. By using an etchant of a type having an anisotropic etching property where side etching in a direction perpendicular to the [001] direction or the [010] direction of the InP crystalline orientation proceeds greatly, the sub-collector layer 101, the collector layer 102, and the base layer 103 under the interconnect 106c are completely removed. At this time, under the base contact pad electrode 106b, a layer 101a formed by the same layer as the sub-collector layer 101, a layer 102a formed by the same layer as the contact layer 102, and a layer 103a formed by the same layer as the base layer 103 are left, whereby a base contact pad base mesa portion PBM is formed. Side etching proceeds somewhat due to the above-mentioned side-etching property, so a base contact pad base mesa portion PBM is formed in a narrower region compared with the region for formation of the base contact pad electrode 106b.

After this, a collector electrode 110 is formed on the sub-collector 101 by vapor deposition using the lift-off method for example, an insulating film 108 is formed by CVD etc., a resist film is formed in a pattern of the contact holes, and the insulating film 108 is etched using the resist as a mask by reactive ion etching (RIE) to open an emitter contact hole CHe, a base contact hole CHb, and a collector contact hole CHc. The contact plug interconnect 109e, the contact plug interconnect 109b, and the contact plug interconnect 109c are formed in the contact holes to form the structure shown in FIG. 1A and FIG. 1B.

Summarizing the problems to be solved by the invention, in the above-mentioned method of producing a semiconductor device of the related art, there are restrictions on the drawn direction of the interconnect 106c and the type of etchant for removing completely the sub-collector layer 101, the collector layer 102, and the base layer 103 under the interconnect 106c. When etching to form the base mesa portion, if the closeness of adhesion of the metal conductive layer 106 and a resist film formed on the step differences of the epitaxially grown semiconductor layer is insufficient, the etchant will invade along the step differences to cause a mesa portion-shaped abnormality.

### SUMMARY OF THE INVENTION

An object of the present invention is to provide a semiconductor device free of the restrictions on the pattern layout or type of etchant used and able to be produced while suppressing mesa portion-shaped abnormalities and a method of producing the same.

To achieve the above object, according to a first aspect of the present invention, there is provided a semiconductor device having a semiconductor mesa portion formed on a substrate, including a stack of at least a collector layer, a base layer, and an emitter layer formed in a narrower region compared with the base layer, and functioning as an active region of a bipolar transistor; a base contact pad mesa portion formed on the substrate apart from the semiconductor mesa portion and formed with a height the same as the height of the top surface of the base layer; and a conductive layer formed integrally with a base electrode formed connected to the base layer at part of a region of formation of the base layer other than the region of formation of the emitter layer, a base contact pad electrode formed above the base contact pad mesa portion in a region other than near the edges of the top surface of the base contact pad mesa portion, and an interconnect for connecting the base electrode and the base contact pad electrode.

The semiconductor device of the present invention has the base contact pad electrode taken out from the base electrode through the interconnect and has a conductive layer formed integrally with the base electrode formed connected to the base layer at part of the region of formation of the base layer other than the region of formation of the emitter layer, the base contact pad electrode formed above the base contact pad mesa portion, and the interconnect for connecting the base electrode and the base contact pad electrode. Here, the base contact pad electrode is formed at a region other than near the edges of the top surface of the base contact pad mesa portion.

According to a second aspect of the invention, there is provided a method of producing a semiconductor device having a bipolar transistor including an emitter layer, a base layer and a collector layer on a substrate, having the steps of forming a stack of at least a collector layer, a base layer, and an emitter layer on a substrate; patterning the stack to form, separated by a predetermined distance, a semiconductor mesa portion including a stack of at least a collector layer, a base layer, and an emitter layer formed in a narrower region than the base layer and functioning as an active region of a bipolar transistor and a base contact pad mesa portion having the same height as the height of the top surface of the base layer and having a surface layer formed by the same layer as the base layer; forming, between the semiconductor mesa portion and the base contact pad mesa portion, a covering layer having a top surface higher than the height of the top surface of the base layer on the substrate and covering at least up to near the edges of the top surface of the base contact pad mesa portion; and forming a conductive layer above the covering layer using the covering layer as a mask and integrally forming a base electrode connected to the base layer at part of the region of formation of the base layer other than the region of formation of the emitter layer, a base contact pad electrode above the base contact pad mesa portion in a region other than near the edges of the top surface of the base contact pad mesa portion, and an interconnect connecting the base electrode and the base contact pad electrode.

The method of producing a semiconductor device of the present invention first forms a stack of at least a collector layer, a base layer, and an emitter layer on the substrate. Next, it patterns the stack to form, a predetermined distance apart, a semiconductor mesa portion including the stack of at least the collector layer, the base layer, and the emitter layer formed in a narrower region than the base layer and functioning as an active region of a bipolar transistor and a base contact pad mesa portion having the same height as the height of the top surface of the base layer and having a surface layer comprised of the same layer as the base layer. Next, it forms, between the semiconductor mesa portion and the base contact pad mesa portion, a covering layer having a top surface higher than the height of the top surface of the base layer on the substrate and covering at least up to near the edges of the top surface of the base contact pad mesa portion. Next, it forms a conductive layer above the covering layer using the covering layer as a mask and integrally forms a base electrode connected to the base layer at part of the region of formation of the base layer other than the region of formation of the emitter layer, a base contact pad electrode above the base contact pad mesa portion at a region other than near the edges of the top surface of the base contact pad mesa portion, and an interconnect connecting the base electrode and the base contact pad electrode.

### BRIEF DESCRIPTION OF THE DRAWINGS

These and other objects and features of the present invention will be described in more detail with reference to the accompanying drawings, in which:
FIG. 1A is a plane view of a semiconductor device including a heterojunction bipolar transistor according to the related art, and FIG. 1B is a cross-sectional view along line X-X' of FIG. 1A;
FIG. 2A to 2D are cross-sectional views of steps of a method of producing a semiconductor device including a heterojunction bipolar transistor according to the related art;
FIG. 3A is a plane view of a semiconductor device including a heterojunction bipolar transistor according to a first embodiment of the present invention, and FIG. 3B is a cross-sectional view along line X-X' of FIG. 3A;
FIG. 4A to 4J are cross-sectional views of steps of a method of producing a semiconductor device including a heterojunction bipolar transistor according to the first embodiment; and
FIG. 5 is a plane view of a semiconductor device including a heterojunction bipolar transistor according to a second embodiment of the present invention.

### DESCRIPTION OF THE PREFERRED EMBODIMENTS

Next, a semiconductor device and a method of producing the same will be explained with reference to the drawings.

### First Embodiment

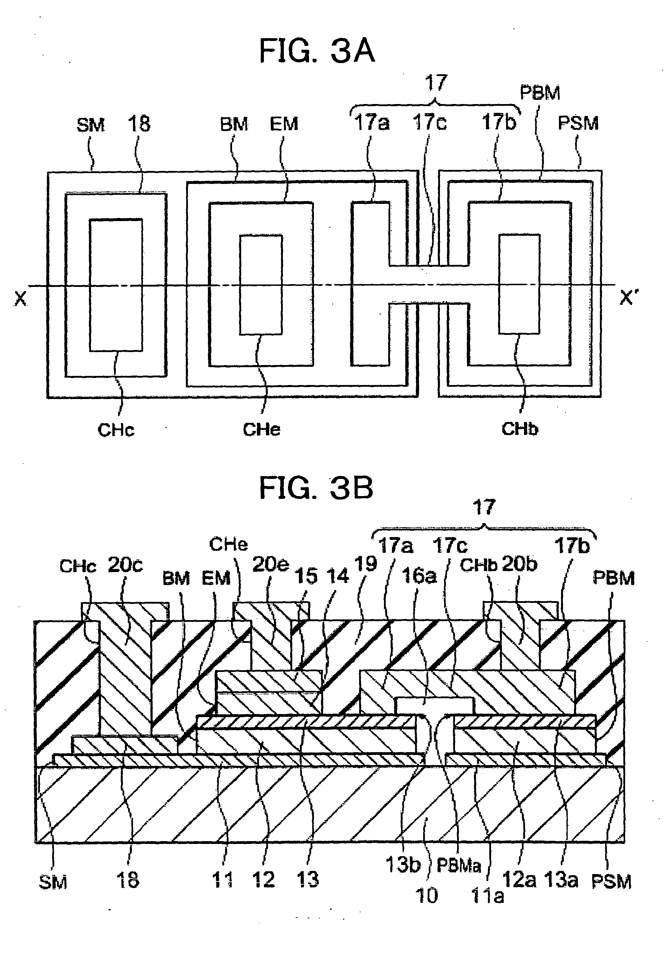

FIG. 3A is a plane view of a semiconductor device including a heterojunction bipolar transistor according to a first embodiment of the present invention, and FIG. 3B is a cross-sectional view along the line X-X' of FIG. 3A. A semi-insulating substrate 10 comprised of an Fe-doped single crystal InP has successively formed on it a sub-collector layer 11 of a thickness of about 500 nm of an n⁺-type InP, a collector layer 12 of a thickness of about 500 nm of an n⁻-type InP, a base layer 13 of a p⁺-type InGaAs, an emitter layer 14 of a thickness of about 75 nm of an n-type InP, and an emitter cap layer (not shown) of a thickness of about 75 nm of an n⁺-type InGaAs and functions as an active region of a heterojunction bipolar transistor. The sub-collector layer 11 includes a higher concentration of conductive impurities than the collector layer 12 and forms a collector takeout layer

An emitter electrode 15 is formed connected to the emitter cap layer. For forming a base contact, the emitter cap layer and the emitter layer 14 are removed in part to form an emitter mesa portion EM. A base electrode 17a is formed connected to the base layer 13, while the base layer 13 and the collector layer 12 are formed with a base mesa portion BM. The sub-collector layer 11 is formed with a sub-collector mesa portion SM, and a collector electrode 18 is formed connected with the sub-collector layer 11. Note that the sub-collector mesa portion SM is a mesa portion for isolating elements.

A predetermined distance of for example 1 to 5 µm away from the end of the base mesa portion BM, a base contact pad base mesa portion PBM having a layer 12a formed by the same layer as the collector layer 12 and a layer 13a formed by the same layer as the base layer 13 is formed. Below this is formed a base contact pad sub-collector mesa portion PSM having a layer 11a formed by the same layer as the sub-collector layer. Therefore, the height of the top surface of the base contact pad base mesa portion PBM becomes the same as the height of the top surface of the base mesa portion BM.

The base contact pad electrode 17b is formed on the base contact pad base mesa portion PBM. Here, the base layer 13 under the base electrode 17a and the layer 13a under the base contact pad electrode 17b are originally formed by the same layer and are the same in heights of the top surfaces. The base electrode 17a and the base contact pad electrode 17b are connected by an interconnect 17c. A base electrode takeout portion is formed for reducing the base-collector capacity. The area between the base mesa portion BM and the base contact pad base mesa portion PBM below the conductive layer 17 forms a space 16a. The interconnect 17c floats above this.
The base contact pad base mesa portion PBM and the sub-collector mesa portion PSM are electrically insulated from the transistor part and other elements by the semiinsulating substrate 10, so the capacities of these parts do not become the parasitic capacitance of the transistor.

The emitter electrode 15, the conductive layer 17 including the base electrode 17a, and the collector electrode 18 are formed by a stack of Ti/Pt/Au for example.

Here, the base contact pad electrode 17b is formed in a region other than near the edges PBMa of the top surface of the base contact pad mesa portion constituted by the base mesa portion PBM. For example, it is formed in a region inside from the edges PBMa of the top surface of the base contact pad base mesa portion PBM in a range of 0.5 to 2 µm. On the other hand, the base electrode 17a is formed in a region other than the region of formation of the emitter layer 14 and other than near the edges 13b of the base layer 13. For example, it is formed in a region inside from the edges 13b of the base layer 13 in a range of 0.5 to 2 µm.

A heterojunction bipolar transistor HBT is formed as explained above. An insulating film 19 is formed covering the entire HBT. The insulating film 19 is formed with an emitter contact hole CHe reaching the emitter electrode 15, a base contact hole CHb reaching the base contact pad electrode 17b, and a collector contact hole CHc reaching the collector electrode 18. The emitter contact hole CHe is formed with an emitter contact plug interconnect 20e connected with the emitter electrode 15. The base contact hole CHb is formed with a base contact plug interconnect 10b connected with the base contact pad electrode 17b. The collector contact hole CHc is formed with a collector contact plug interconnect 20c connected with the collector electrode 18.

The semiconductor device having an HBT according to the present embodiment is configured provided with an external takeout contact pad from the base electrode without increasing the base-collector capacity and can prevent degradation of the high frequency properties of the devices. The height of the top surface of the base contact pad base mesa portion PBM is the same as the height of the top surface of the base mesa portion BM, so it is possible to form an air bridge at the interconnect for taking out the base with a good shape.

The base contact pad electrode 17b is formed in the region other than near the edges PBMa of the top surface of the base contact pad mesa portion constituted by the base mesa portion PBM. The base electrode 17a is formed in a region other than the region of formation of the emitter layer 14 and other than near the edges 13b of the base layer 13. As explained later, by the method of forming a resist film or other covering layer between the base contact pad mesa portion and the base mesa portion and forming a conductive layer using this as a mask, it becomes possible to easily form the base contact pad electrode 17b and the base electrode 17a of the above structure. By using this method for production, it is possible to eliminate the restrictions on the pattern layout, the types of the etchant used, etc., suppress the occurrence of mesa portion-shaped abnormalities, and maintain the shape of the mesa etching well for production.

Since the base mesa portion BM and the base contact pad base mesa portion PBM are arranged separated by 1 to 5 µm, the device area of the HBT can be reduced. The thickness of the interconnect 17c is a thin one of about 0.2 to 0.5 µm and the strength is insufficient, so if increasing the distance, the interconnect 17c is liable to be damaged. To prevent this, it is preferable to set the distance between the base mesa portion BM and the base contact pad base mesa portion PBM to the above range.

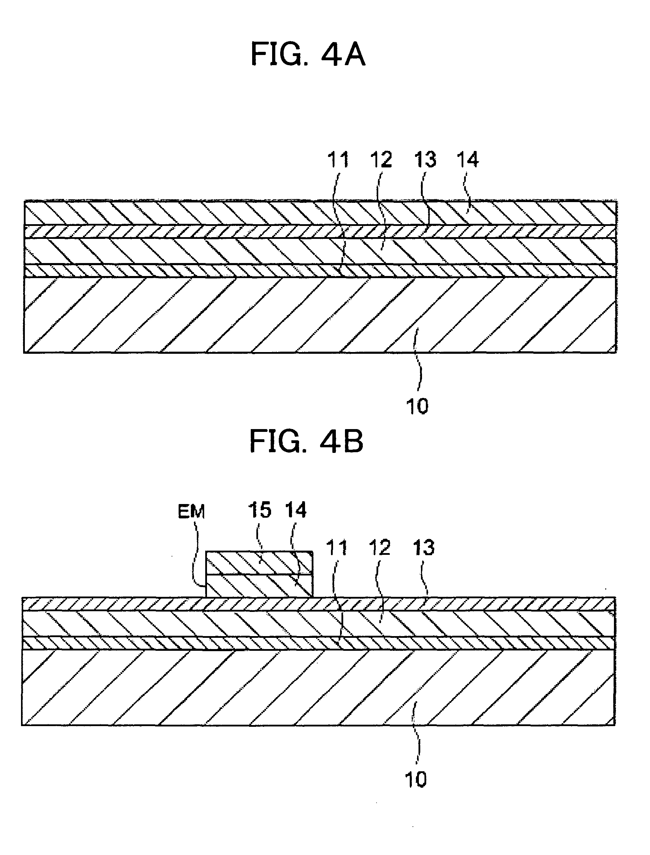

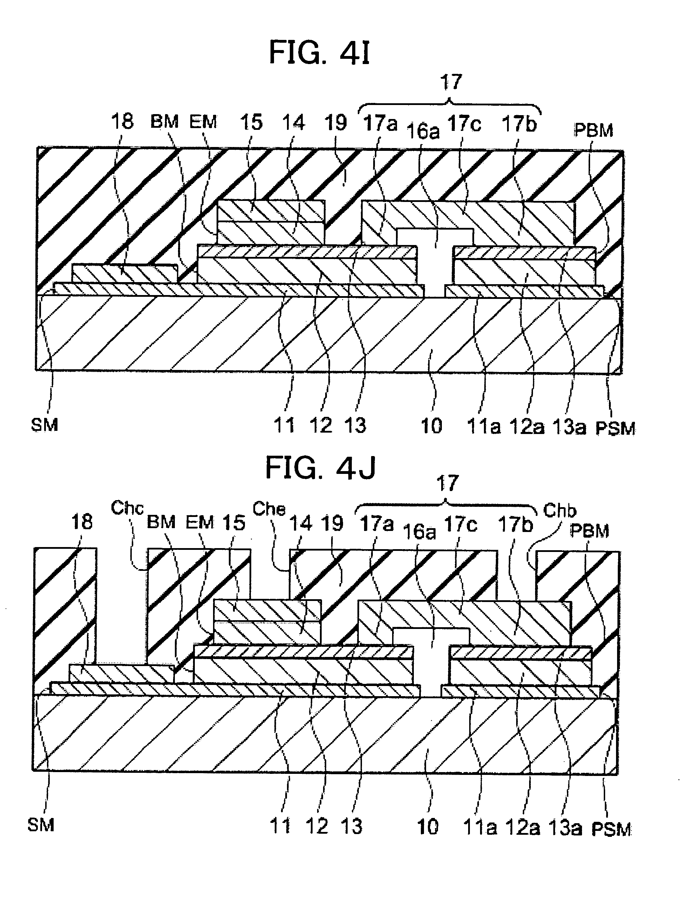

The method of producing a semiconductor device having an HBT according to the present embodiment will be explained with reference to the drawings. First, as shown in FIG. 4A, a semi-insulating substrate 10 comprised of Fe-doped single crystal InP is successively formed with, by the MBE or the MOCVD, an n⁺-type InGaAs as the sub-collector layer 11, an n⁻-type InP as the collector layer 12, a p⁺-type InGaAs as the base layer 13, an n-type InP as the emitter layer 14, and an n⁺-type InGaAs as the emitter cap layer (not shown).

Next, as shown in FIG. 4B, an emitter electrode 15 is formed on the emitter layer 14 by for example the lift-off method etc. Next, a not shown resist film used for patterning the emitter electrode 15, the emitter electrode 15, etc. is used as a mask to successively process the emitter cap layer and the emitter layer 14 to emitter mesa portion EM. Due to this, the surface of the base layer 13 is exposed. In the above-mentioned etching, the InGaAs of the emitter cap layer is etched by using a mixture of phosphoric acid, hydrogen peroxide, and water, while the InP of the emitter layer is etched by using a mixture of hydrochloric acid and phosphoric acid.

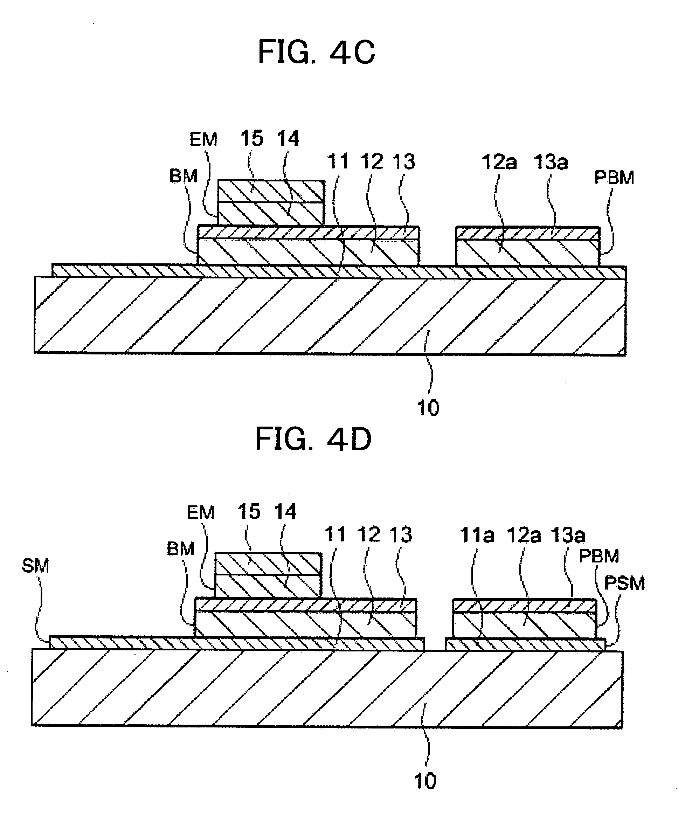

Next, as shown in FIG. 4C, a resist film (not shown) is formed in the pattern of the base mesa portion BM and the base contact pad base mesa portion PBM. This is used as a mask for etching to process the base layer 13 and the collector layer 12 to the base mesa portion BM. Simultaneously, a layer 12a formed by the same layer as the collector layer 12 and a layer 13a formed by the same layer as the base layer 13 are patterned as the base contact pad base mesa portion BM. In the same way as the above, for example, the InGaAs of the base layer 13 is etched using a mixture of phosphoric acid, hydrogen peroxide, and water, while the InP of the collector layer 12 is etched using a mixture of hydrochloric acid and phosphoric acid.

Next, as shown in FIG. 4D, a resist film (not shown) is formed in a pattern of the sub-collector mesa portion SM and the base contact pad sub-collector mesa portion PSM. This is used as a mask for etching to process the sub-collector layer 11 to the sub-collector mesa portion SM and isolate the elements. Simultaneously, the layer 11a formed by the same layer as the sub-collector layer 11 is patterned to form the base contact pad sub-collector mesa portion PSM. In the same way as the above, for example, the InGaAs of the sub-collector layer 11 is etched using a mixture of phosphoric acid, hydrogen peroxide, and water.

In this way, the semiconductor mesa portion of the emitter mesa portion EM, the base mesa portion BM, and the sub-collector mesa portion SM functioning as an active region of a heterojunction bipolar transistor and a base contact pad mesa portion constituted by the base mesa portion PBM and the sub-collector mesa portion PSM having a height the same as the height of the top surface of the base layer and having a surface layer formed by the same layer as the base layer are formed separated by a predetermined distance.

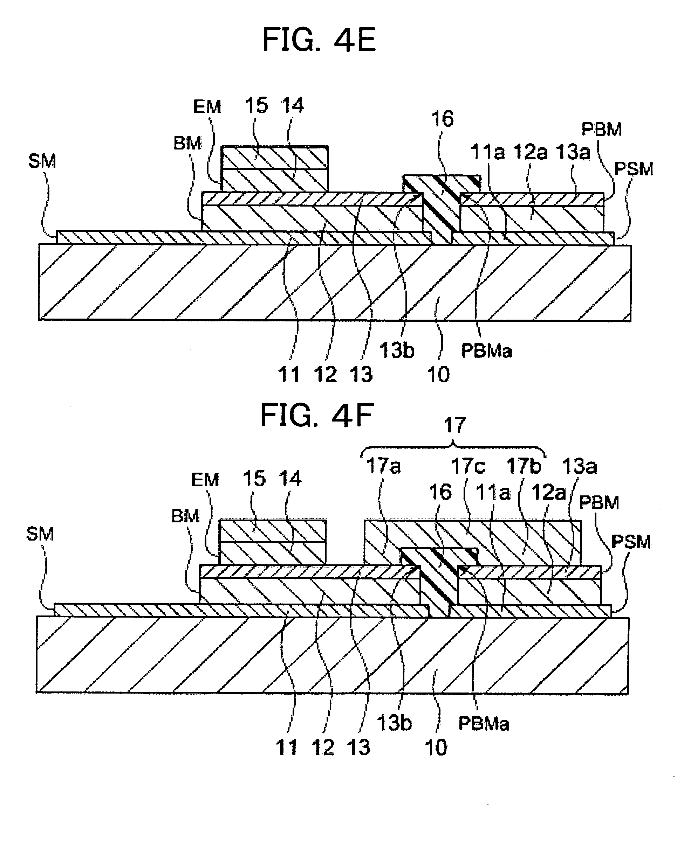

Next, as shown in FIG. 4E, between the semiconductor mesa portion of the emitter mesa portion EM, the base mesa portion BM, and the sub-collector mesa portion SM and a base contact pad mesa portion constituted by the base mesa portion PBM and sub-collector mesa portion PSM, a resist film 16 is patterned on the substrate 10 as a covering layer having a top surface higher than the height of the top surface of the base layer 13 so as to cover at least up to near the edges PBMa of the top surface of the base contact pad base mesa portion PBM (region of 0.5 to 2 µm from the edges PBMa) and cover up to near the edges 13b of the base layer 13 (region of 0.5 to 2 µm from the edges).

Next, as shown in FIG. 4F, for example vapor deposition using the lift-off method etc. is used to form a conductive layer 17 of a thickness of about 0.2 to 0.5 µm above the resist film 16 using the resist film 16 as a mask. In other words, a base electrode 17a connected to the base layer at part of the region other than the region of formation of the emitter layer 14 and other than near the edges 13b of the base layer 13, a base contact pad electrode 17b above the base contact pad base mesa portion in the region other than near the edges PBMa of the top surface of the base contact pad base mesa portion PBM, and an interconnect 17c connecting the base electrode 17a and the base contact pad electrode 17b are integrally formed.

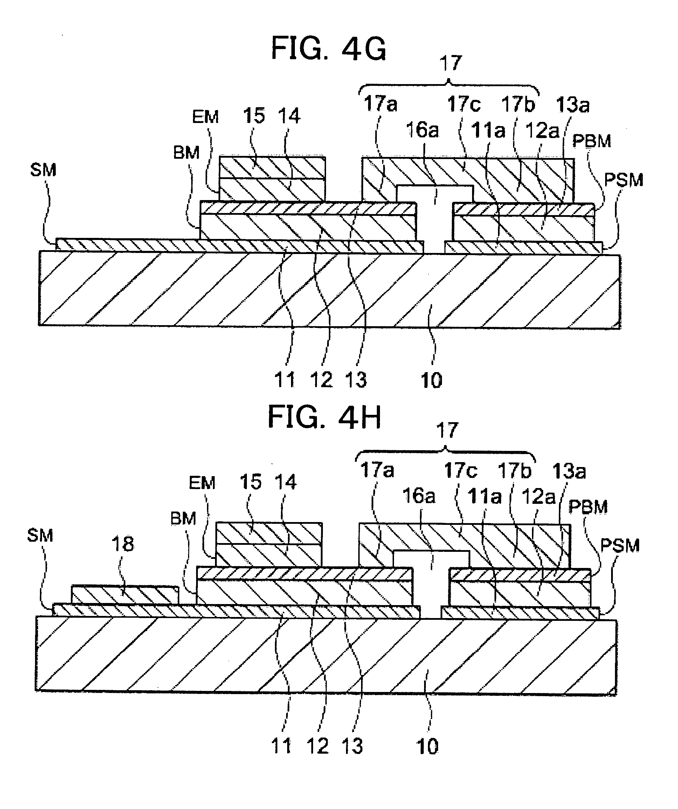

Next, as shown in FIG. 4G, the resist film 16 is removed. Due to this, the area below the conductive layer 17 between the semiconductor mesa portion of the emitter mesa portion EM, the base mesa portion BM, and the sub-collector mesa portion SM and the base contact pad mesa portion constituted by the base mesa portion PBM and the sub-collector mesa portion PSM forms a space 16a and becomes an air bridge structure.

Next, as shown in FIG. 4H, a collector electrode 18 is formed on the sub-collector layer 11 by vapor deposition using for example the lift-off method. A heterojunction bipolar transistor HBT is formed by the above.

Next, as shown in FIG. 4I, for example, CVD is used to deposit silicon oxide over the entire surface covering the entire HBT to form an insulating film 19. At that time, sometimes part of the insulating film is formed sneaking into the space 16a under the interconnect 17c, but it is possible to prevent the film from sneaking into and leave the space as it is depending on the film-forming conditions.

Next, as shown in FIG. 4J, CVD etc. is used to form an insulating film 19, a resist film is formed in the pattern of the contact holes, and the insulating film is etched by reactive ion etching (RIE) to form the emitter contact hole CHe, the base contact hole CHb, and the collector contact hole CHc. As subsequent steps, the contact holes are formed with a contact plug interconnect 20e, a contact plug interconnect 20b, and a contact plug interconnect 20c. Using the above, a semiconductor device having an HBT of a structure similar to the structure shown in FIG. 3A and FIG. 3B can be produced.

According to the method of producing a semiconductor device of the present embodiment, since the height of the top surface of the base contact pad base mesa portion PBM is the same as the height of the top surface of the base mesa portion BM, it is possible to form an air bridge of the interconnect for taking out the base in a good shape. Further,since the mesa shape is formed without etching utilizing the side etching property based on the crystalline orientation of the substrate, then a conductive layer 17 integrally formed of a base electrode 17a, a base contact pad electrode 17b, and an interconnect 17c is formed, there is no restriction on the pattern layout, the type of the etchant used, etc. When etching to form the base mesa portion, it is possible to etch in the state with no step difference possibly causing mesa shape abnormalities, suppress the occurrence of mesa shape abnormalities, and keep the shape of the mesa etching good in the producing the device.

### Second Embodiment

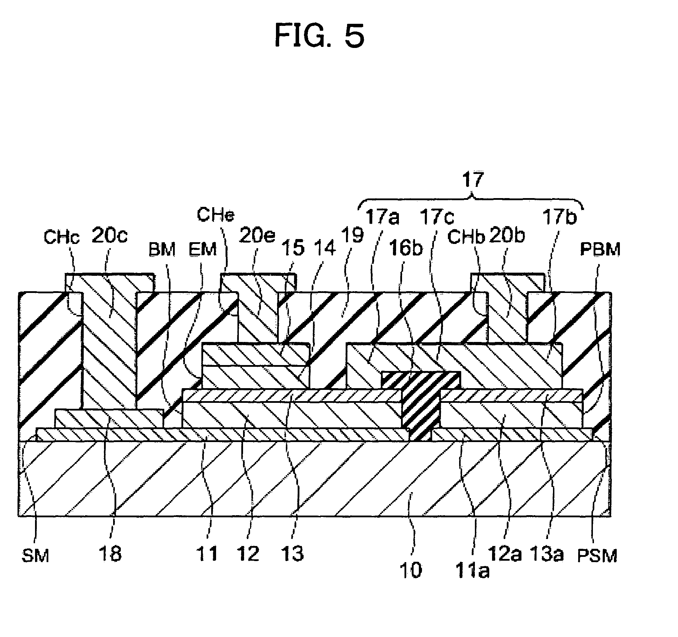

FIG. 5 is a cross-sectional view of a semiconductor device having a heterojunction bipolar transistor according to a second embodiment of the present invention.

The semiconductor device of the second embodiment is similar to the semiconductor device of the first embodiment, but differs in the point that a silicon oxide or other insulating film 16b is formed in the space formed below the conductive layer 17 between the semiconductor mesa portion of the emitter mesa portion EM, the base mesa portion BM, and the sub-collector mesa portion SM and the base contact pad mesa portion constituted by the base mesa portion PBM and the sub-collector mesa portion PSM.

Since a silicon oxide or other insulating film has a higher dielectric constant than air, the electrostatic capacity of this part rises somewhat in the semiconductor device of the present embodiment. In the same way as the first embodiment, as explained above, by forming an insulating film of silicon oxide or another covering layer between the base contact pad mesa portion and the base mesa portion and forming a conductive layer using this as a mask, it becomes possible to easily form the base contact pad electrode 17b and the base electrode 17a of the above structure. Since this method is used for production, production is possible while eliminating the restrictions on the pattern layout, type of the etchant used, etc. and suppressing the occurrence of mesa shape abnormalities.

The semiconductor device according to this embodiment can be produced in substantially the same way as the first embodiment. In other words, in the step of forming the resist film 16 as a covering layer in the first embodiment, a silicon oxide or other insulating film 16b is formed as a covering layer. In the step of forming the conductive layer 17 using the covering layer as a mask above the covering layer, the conductive layer is formed above the insulating film 16b using the insulating film 16b as a mask. By leaving this and performing the following steps in the same way as the first embodiment, it is possible to form the structure shown in FIG. 5.

According to the method of producing a semiconductor device of the present embodiment, in the same way as the first embodiment, since there is no etching utilizing the side-etching property based on the crystalline orientation of the substrate, there is no restriction on the pattern layout, type of etchant used, etc. When etching for forming a base mesa portion, etching is possible in a state with no step difference possibly causing mesa portion-shaped abnormalities and the occurrence of mesa portion-shaped abnormalities can be suppressed.

The present invention is not limited to the above embodiments. For example, in the above embodiments, a base mesa portion PBM and sub-collector mesa portion PSM are used as the base contact pad mesa portion, but the invention is not limited to this. It is also possible to form a new mesa portion for the base contact pad. Note that in the above case, the height of the top surface of the base contact pad mesa portion has to be designed to become the same as the height of the top surface of the base layer. Further, the base electrode 17a does not necessarily have to be formed in the region other than the region of formation of the emitter layer 14 and other than near the edges 13b of the base layer 13. It is sufficient that at least the base contact pad electrode 17b is formed in a region other than near the edges PBMa of the top surface of the base contact pad mesa portion constituted by the base mesa portion PBM. However, the structure becomes easier to produce by also forming the base electrode 17a in a region other than near the edges 13b of the base layer 13.

Further, in the above embodiments, the explanation was given with reference to an npn-type bipolar transistor, but the invention can also be applied to a pnp-type bipolar transistor. Further, the shapes of the mesa portion of the stack of the collector layer, the base layer, and the emitter layer, the arrangement of the electrodes connected to the different layers, etc. are not limited to the above embodiments. Other shapes and arrangements may also be employed. In addition, the present invention is not limited to heterojunction bipolar transistors and may be applied to semiconductor devices having other bipolar transistors as well.

Summarizing the effects of the invention, the semiconductor device of the present invention can be produced without restriction as to the pattern layout, type of etchant used, etc. and while suppressing mesa portion-shaped abnormalities. According to the method of producing a semiconductor device of the present invention, it is possible to produce a semiconductor device without restriction as to the pattern layout, type of etchant used, etc. and while suppressing mesa shape abnormalities.

While the invention has been described with reference to specific embodiments chosen for purpose of illustration, it should be apparent that numerous modifications could be made thereto by those skilled in the art without departing from the basic concept and scope of the invention.

## Claims

1. A semiconductor device comprising:
a semiconductor mesa portion formed on a substrate (10), including a stack of at least a collector layer (12), a base layer (13), and an emitter layer (14) formed in a narrower region compared with said base layer (13), and functioning as an active region of a bipolar transistor;
a base contact pad mesa portion (PBM) formed on said substrate apart from said semiconductor mesa portion and formed with a height the same as the height of the top surface of said base layer (13); and
a conductive layer (17) formed integrally with a base electrode (17a) formed connected to said base layer (13) at part of a region of formation of said base layer other than the region of formation of said emitter layer, a base contact pad electrode (17b) formed above said base contact pad mesa portion (PBM) in a region other than near the edges of the top surface of said base contact pad mesa portion (PBM), and an interconnect (17c) for connecting said base electrode and said base contact pad electrode (17b).

2. A semiconductor device as set forth in claim 1, wherein the surface layer of said base contact pad mesa portion (PBM) is formed by the same layer as said base layer (13).

3. A semiconductor device as set forth in claim 1, wherein the area under said conductive layer between said semiconductor mesa portion and said base contact pad mesa portion (PBM) forms a space (16a).

4. A semiconductor device as set forth in claim 1, wherein an insulating film (19) is formed below said conductive layer between said semiconductor mesa portion and said base contact pad mesa portion (PBM).

5. A semiconductor device as set forth in claim 1, wherein said base electrode (17a) is formed in a region other than the region of formation of said emitter layer (14) and other than near the edges of said base layer (13).

6. A semiconductor device as set forth in claim 1, wherein a distance between said semiconductor mesa portion and said base contact pad mesa portion (PBM) is 1 to 5 µm.

7. A semiconductor device as set forth in claim 1, wherein said semiconductor mesa portion is comprised of a stack of a compound semiconductor and has a heterojunction bipolar transistor.

8. A method of producing a semiconductor device having a bipolar transistor including an emitter layer, a base layer and a collector layer on a substrate, comprising the steps of:
forming a stack of at least a collector layer (12), a base layer (13), and an emitter layer (14) on a substrate (10);
patterning said stack to form, separated by a predetermined distance, a semiconductor mesa portion including a stack of at least a collector layer (12), a base layer (13), and an emitter layer (14) formed in a narrower region than said base layer (13) and functioning as an active region of a bipolar transistor and a base contact pad mesa portion (PBM) having the same height as the height of the top surface of said base layer (13) and having a surface layer comprising the same layer as said base layer;
forming, between said semiconductor mesa portion and said base contact pad mesa portion (PBM), a covering layer (16) having a top surface higher than the height of the top surface of said base layer (13) on said substrate (10) and covering at least up to near the edges of the top surface of said base contact pad mesa portion (PBM); and
forming a conductive layer (17) above said covering layer (16) using said covering layer as a mask and integrally forming a base electrode (17a) connected to said base layer (13) at part of the region of formation of said base layer other than the region of formation of said emitter layer (11), a base contact pad electrode (17b) above said base contact pad mesa portion (PBM) in a region other than near the edges of the top surface of said base contact pad mesa portion (PBM), and an interconnect (17c) connecting said base electrode (17a) and said base contact pad electrode (17b).

9. A method of producing a semiconductor device as set forth in claim 8, further comprising the step of removing said covering layer after the step of forming said conductive layer.

10. A method of producing a semiconductor device as set forth in claim 8, wherein the step of forming said covering layer comprises forming said covering layer by an insulating film.

11. A method of producing a semiconductor device as set forth in claim 8, wherein:
the step of forming said covering layer comprises forming said layer so as to cover up to near the edges of said base layer (13) of said semiconductor mesa portion; and
the step of forming said conductive layer comprises forming said base electrode (17a) in a region other than the region of formation of said emitter layer (14) and other than near the edges of said base layer (13).

12. A method of producing a semiconductor device as set forth in claim 8, comprising forming said semiconductor mesa portion by a compound semiconductor to form a heterojunction bipolar transistor.
